Europäisches Patentamt

European Patent Office

Office européen des brevets

(19)

(11) **EP 0 710 848 A1**

(12) **DEMANDE DE BREVET EUROPEEN**

(43) Date de publication:
08.05.1996 Bulletin 1996/19

(51) Int Cl.⁶: **G01R 31/12**, G01R 27/26

(21) Numéro de dépôt: 95402436.0

(22) Date de dépôt: 02.11.1995

(84) Etats contractants désignés:
**CH DE DK FR GB IT LI NL SE**

(30) Priorité: **02.11.1994 FR 9413077**

(71) Demandeur: **ALCATEL CABLE
F-92100 Clichy (FR)**

(72) Inventeurs:
• **Coelho, Roland
F-92420 Vaucresson (FR)**

• **Aladenize, Bernard
F-91360 Epinay sur Orge (FR)**
• **Mirebeau, Pierre
F-941140 Villebon S/Yvette (FR)**

(74) Mandataire: **El Manouni, Josiane
SOSPI
14-16, rue de la Baume
F-75008 Paris (FR)**

(54) **Procédé de mesure du déclin de potentiel et de la mobilité électronique d'un matériau**

(57)     L'invention a pour objet un procédé pour la mesure du déclin de potentiel dV/dt d'un matériau isolant, caractérisé en ce qu'il comprend les étapes suivantes:

-     on place un élément (1) constitué dudit matériau isolant dans l'enceinte (2) d'un microscope électronique,

-     on dépose, en un point-cible (0) dudit élément, une charge électronique au moyen du dispositif (3) d'émission électronique du microscope,

-     on mesure, au moyen d'un voltmètre (6), la variation en fonction du temps du potentiel audit point cible.

    Par un traitement mathématique, on peut déduire la valeur de la mobilité électronique du matériau isolant.

FIG.1

## Description

La présente invention concerne la mesure de la mobilité électronique d'un matériau isolant ou diélectrique.

La mobilité électronique d'un matériau est une grandeur propre à chaque matérieu isolant ou diélectrique. Sa connaissance est indispensable pour déterminer l'aptitude de certains matériaux nouveaux à une utilisation industrielle, par exemple dans la construction des câbles électriques ou des isolateurs.

La mesure de la mobilité électronique s'effectue en déposant sur un échantillon, généralement plan, du matériau à étudier, une charge électrique. On observe, à l'aide d'un voltmètre électronique, le déclin de potentiel en fonction du temps. Un traitement mathématique adéquat permet d'en déduire la mobilité électronique du matériau.

La mesure du déclin de potentiel requiert un appareil d'une grande propreté, en raison des charges électriques mises en jeu dont la migration peut être affectée par un des facteurs extérieurs à l'échantillon (air ambiant, poussières, etc...)

Par ailleurs, il est important de pouvoir connaître avec précision la quantité de charges déposées sur l'échantillon.

Un premier but de l'invention est de définir un procédé pour la mesure du déclin de potentiel qui permette d'éviter les inconvénients précités.

Un autre but de l'invention est de définir un traitement mathématique du résultat de la mesure du déclin de potentiel pour en déduire la valeur de la mobilité électronique.

La présente invention a pour objet un procédé pour la mesure du déclin de potentiel dV/dt d'un matériau isolant, caractérisé en ce qu'il comprend les étapes suivantes:

- on place un élément constitué dudit matériau isolant dans l'enceinte d'un microscope électronique,
- on dépose, en un point-cible dudit élément, une charge électronique au moyen du dispositif d'émission électronique du microscope,
- on mesure, au moyen d'un voltmètre, la variation en fonction du temps du potentiel audit point cible.

L'invention a également pour objet un procédé pour la détermination de la mobilité électronique d'un matériau isolant, caractérisé en ce qu'il comprend les étapes suivantes:

- on place un élément constitué dudit matériau isolant dans l'enceinte d'un microscope électronique,
- on dépose, en un point-cible dudit élément, une charge électronique au moyen du dipositif d'émission électronique du microscope,
- on mesure, au moyen d'un voltmètre, la variation en fonction du temps du potentiel audit point-cible,
- on détermine, à l'aide d'un modèle mathématique, la valeur de la mobilité électronique, ledit modèle faisant l'hypothèse d'une distribution initiale triangulaire de la charge initiale.

L'invention est expliquée en détail par la description ci-après d'un mode préféré de mise en oeuvre de l'invention, en référence au dessin annexé dans lequel:

- la figure 1 représente très schématiquement la chambre de mesure d'un miscroscope électronique dans lequel est placé un échantillon dont on souhaite mesurer la mobilité électronique,
- la figure 2A représente, dans un modèle dit du plan de charge, la variation en fonction du temps du potentiel créé par une charge tandis que la figure 2B représente, da,s le même modèle, la variation du même potentiel en fonction de la distance du point d'impact,
- la figure 3A illustre un modèle dit à distribution triangulaire de la charge initiale,
- la figure 3B représente l'évolution dans le temps de la charge initiale dans le modèle de la figure 3A.

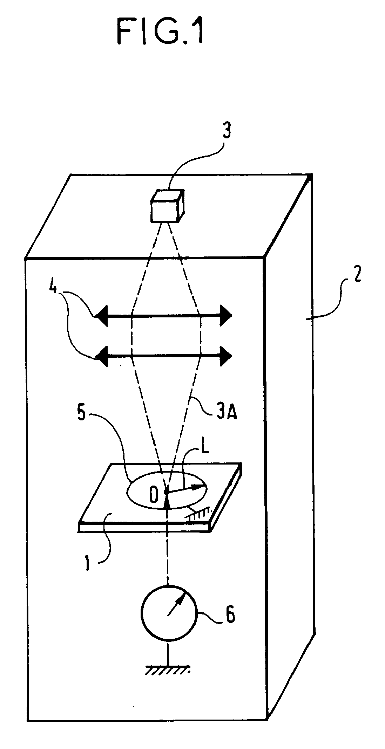

Dans la figure 1, la référence 1 désigne un échantillon d'un matériau diélectrique dont on veut mesurer la mobilité électronique.

L'échantillon est placé à l'intérieur de la chambre de mesure d'un microscope électronique représentée symboliquement par le rectangle 2. A l'intérieur de cette chambre règne le vide. Un canon à électrons 3 permet de diriger sur l'échantillon, en un point-cible O, un flux d'électrons 3A; grâce à une focalisation réalisée classiquement à l'aide de lentilles 4, les dimensions de la zone irradiée sont parfaitement maîtrisées. A une distance L du point cible O est placée une contre-électrode 5 au potentiel de la masse. Après irradiation du point-cible O, on connecte un voltmètre électronique 5 qui permet de mesurer le potentiel V, ainsi que la dérivée dV/dt de ce potentiel, appelé également déclin de potentiel.

L'utilisation de la chambre d'un microscope électronique, dans laquelle règne un vide poussé, permet d'une part d'éviter les perturbations atmosphériques qui nuiraient à la conservation de la charge électrique déposée sur l'échantillon si la mesure était faite à l'atmosphère; par ailleurs, l'utilisation du canon à élecrons permet de connaître avec précision la quantité de charges mise en jeu; en outre la focalisation précise du faisceau d'électrons permet de maîtriser les dimensions de la zone irradiée.

Connaissant la valeur du déclin de potentiel dV/dt, il est possible d'en déduire la valeur de la mobilité par un traitement mathématique convenable. On admet que le déclin de potentiel résulte exclusivement de l'évolution de la charge initialement localisée sur ou près de la surface de l'échantillon.

On admet que le problème est et reste unidimentionnel, c'est-à-dire que toutes les quantités intervenant ne dépendent que de la profondeur. Ceci est réalisé pour tout échantillon plan-parallèle à surfaces lisses, constitué d'un matériau macroscopiquement homogène.

On admet aussi que le champ devant la face chargée reste nul, ce qui est le cas lorsque le potentiel est mesuré à l'aide d'une sonde asservie.

On admet enfin que le matériau ne contient pas de charges intrinsèques, mais que les charges déposées peuvent s'y propager, sous l'action du champ qu'elles rayonnent, vers la contre-électrode à la masse, avec une mobilité constante $\mu$, de sorte que l'on peut affecter au matériau une conductivité locale $\sigma(x,t) = \mu\rho(x,t)$ à la profondeur x où la concentration de charge est $\rho(x,t)$.

La densité de courant, dans le circuit extérieur, est la somme du courant de conduction local $\mu\rho E$, du courant de diffusion $D\delta\rho/\delta x$ et du courant de déplacement $\varepsilon\delta E/\delta t$. La somme de ces trois courants reste nulle, puisque le circuit est ouvert.

Ainsi, en utilisant l'équation de Poisson pour $\rho$ et la relation d'Einstein pour D, on obtient l'équation générale:

$$\mu E\delta E/\delta x \pm (\mu kT/\varepsilon e)\delta^2 E/\delta x^2 + \delta E/\delta t = 0 \qquad (1)$$

Toutefois, le rapport entre le terme de diffusion et le terme de conduction est de l'ordre de 2kT/eV, où V est le potentiel entre électrodes. Ainsi, pour des tensions de plusieurs milliers de volts, la diffusion est négligeable au moins dans la mesure où la distribution est continue. Dans cette hypothèse, l'équation (1) se réduit à:

$$\mu E\delta E/\delta x + \delta E/dt = 0 \qquad (2)$$

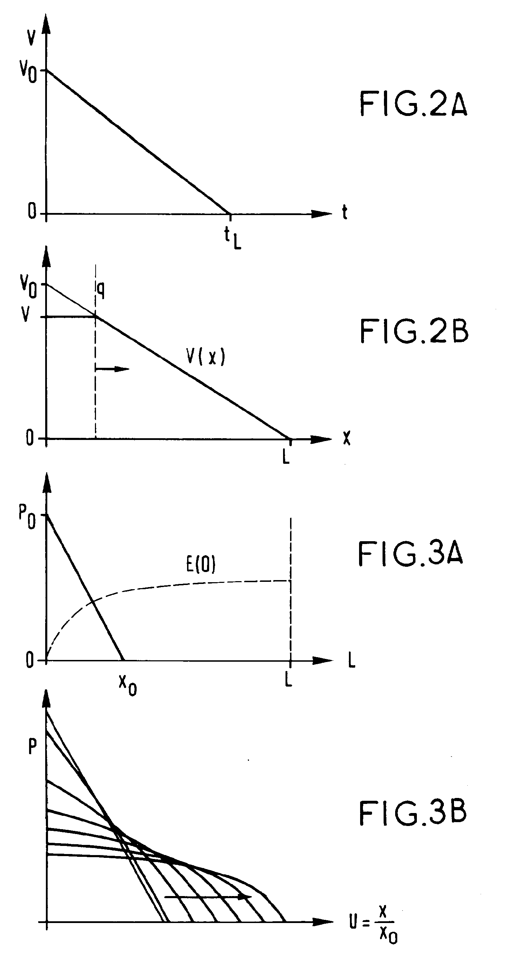

Un premier modèle mathématique décrit maintenant est celui dit du plan de charge, illustré par les figures 2A et 2B.

La charge q (exprimée en $C/m^2$), initialement concentrée en x = 0, crée un champ $q/\varepsilon = v_o/L$ entre elle et la contre-électrode. Elle se propage donc vers cette contre-électrode avec la vitesse:

$$v = \mu E = \mu V_o/L \qquad (3)$$

jusqu'à l'instant $t_L$, temps de transit défini par $v.t_L = L$ soit:

$$t_L = L^2/\mu V_o$$

Ainsi, pour $t < t_L$, le potentiel V décroît linéairement:

$$V(t) = Vo - \mu(V_o/L)^2 t \qquad (4)$$

et il s'annule pout $t = t_L$

Le taux de décroissance permet d'en déduire $\mu$:

$$\mu = (L/V_O)^2 dV/dt$$

Ce modèle est grossier et peu satisfaisant pour les deux raisons suivantes:

1) un plan de charge est une vue de l'esprit car même s'il peut être une bonne approximation à t = 0, il ne peut se maintenir tel quel à cause de la diffusion qui tend à l'élargir,

2) si les charges sont effectivement déposées sur la surface, elles doivent traverser une barrière interfaciale pour pénéter dans l'échantillon. Or la pénétration de ces charges est contrôlée par une cinétique particulière, dont la vitesse dépend de la concentration des charges qui sont encore sur la surface à l'instant considéré.

Pour ces raisons, un modèle de charges initiales réparties dans l'épaisseur semble préférable. On fait l'hypothèse d'une charge initiale uniforme de densité $\rho_o$ sur une profondeur $x_o$.

On choisit de préférence un modèle dit de distribution triangulaire, avec référence aux figures 3A et 3B.

Ce modèle ne peut être traité qu'en utilisant une solution générale de l'équation 2 aux dérivées partielles en E, qui a été établie par le Professeur Laubin de l'Université de Liège;

En posant, pour alléger l'écriture:

$\rho_o x_o = 2q$, q étant la charge totale par unité d'aire (constante jusqu'à ce que le front de distribution atteigne la contre-électrode)

$$x/x_o = u$$

La distribution triangulaire est caractérisée en ce que l'extrémité de la charge, initialement en $x_o$, se déplace comme $(1 + \theta/2)x_o$, donc avec deux phases successives selon que $(1 + \theta/2)$ est inférieur ou supérieur à $L/x_o$, la variable $\theta$ étant

égale à $\mu\rho_o t/\varepsilon$.

La solution de l'équation (2), après simplification, et avec la distribution triangulaire ci-dessus, peut s'écrire:

$$E(u, \theta) = 2q/\varepsilon[((1+\theta)^2 -2u\theta)^{1/2} +u\theta -(1+\theta)] \quad (5)$$

pour u compris entre 0 et $1+\theta/2$

et:

$$E(u, \theta) = q/\varepsilon \qquad (6)$$

pour $u > 1+\theta/2$

L'expression $E(u, \theta)$ devient unique pour $\theta$ supérieur ou égal à $\theta_L = 2(L/xo - 1)$.

Quant au potentiel $V(\theta) =$ Intégrale de 0 à L de E.dx, il s'écrit:

$$(q/\varepsilon) (L-xo/3 -xo\theta/4) \qquad (7)$$

pour $\theta$ inférieur ou égal à $\theta L$,

et:

$$2qx_o/3\varepsilon[(1+(1/\theta))^3 - [(1+(1/\theta))^2 -2L/x_o\theta]^{3/2}] -2qL/\varepsilon\theta [1+(1/\theta)-L/2x_o] \qquad (8)$$

pour $\theta > \theta_L$.

En résumé, dans la première phase $[1+(\theta/2)] < L/x_o$, V décroît linéairement

$dV/dt = (\mu/2) (q/\varepsilon)^2$

d'où

$$\mu = 2[L/V(0)]^2 dV/dt, \qquad (9)$$

où V (0) représente le potentiel à t = 0

si $x_o$ est très inférieur à L. Le front de charge se propage avec la même pente que la distribution initiale Dans la seconde phase, l'extrémité de la charge atteint la contre-électrode à $\theta_L = 2((L/xo)-1)$

et $V(\theta_L) = [((L+(x_o/3))/((L-(x_o/3))]V(0)/2$

Pour $\theta > \theta_L$, le déclin est donné par la relation (8) ci-dessus, et sa forme asymptotique pour $\theta$ très supérieur à $\theta_L$ se réduit à:

$$V(t) = L^2/2\mu t \qquad (10)$$

Ce modèle mathématique permet d'obtenir la mobilité électronique par trois calculs distincts:

- un premier par la formule correspondant à la phase initiale, linéaire, du déclin de potentiel (formule (9)),
- un deuxième par la formule correspondant à la phase intermédiaire du déclin de potentiel (formule (8)),
- un troisième par la formule (10) correspondant à la phase terminale du déclin de potentiel.

Grâce aux caractéristiques expérimentales de l'invention et au modèle mathématique utilisé, il est possible d'obtenir une bonne valeur de la mobilité électronique.

## Revendications

1. Procédé pour la mesure du déclin de potentiel dV/dt d'un matériau isolant, caractérisé en ce qu'il comprend les étapes suivantes:

    - on place un élément (1) constitué dudit matériau isolant dans l'enceinte (2) d'un microscope électronique,
    - on dépose, en un point-cible (0) dudit élément, une charge électronique au moyen du dispositif (3) d'émission électronique du microscope,
    - on mesure, au moyen d'un voltmètre (6), la variation en fonction du temps du potentiel audit point cible.

2. Procédé pour la détermination de la mobilité électronique d'un matériau isolant, caractérisé en ce qu'il comprend les étapes suivantes:

    - on place un élément (1) constitué dudit matériau isolant dans l'enceinte (2) d'un microscope électronique,
    - on dépose, en un point-cible (0) dudit élément, une charge électronique au moyen du dipositif (3)d'émission électronique du microscope,
    - on mesure, au moyen d'un voltmètre (6), la variation en fonction du temps du potentiel audit point-cible,
    - on détermine, à l'aide d'un modèle mathématique, la valeur de la mobilité électronique, ledit modèle faisant l'hypothèse d'une distribution initiale triangulaire de la charge initiale.

3. Procédé selon la revendication 2, caractérisé en ce que le potentiel décroît :

- dans une première phase suivant une loi du type :

$$v(t) = (\mu/2) (q/\varepsilon)^2 t$$

- dans une phase intermédiaire suivant une loi du type :

$$V(\theta)=(2qx_o/3\varepsilon[(1+(1/\theta))^3-[(1+(1/\theta))^2-2L/x_o\theta]^{3/2}]-2qL/\varepsilon\theta[1+(1/\theta)-L/2x_o]$$

- dans une phase finale avec une forme asymptotique du type :

$$V(t)=L^2/2\mu t$$

avec :

$\mu$ : mobilité électronique dudit matériau isolant

$$\theta=\mu\rho_o t/\varepsilon$$

q : charge totale par unité& d'aire

$\rho o$ = densité de charge

$x_o$ : profondeur de la zone chargée

L : profondeur à laquelle est placée, sous l'échantillon, une contre-électrode à la masse.

# FIG.1

FIG.2A

FIG.2B

FIG.3A

FIG.3B

EP 0 710 848 A1

**Office européen des brevets**

## RAPPORT DE RECHERCHE EUROPEENNE

Numero de la demande

EP 95 40 2436

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | REVUE GENERALE DE L'ELECTRICITE, no. 77, Juillet 1985 PARIS FR, pages 576-584, COELHO ET AL. 'METHODES DE CARACTERISATION DES MATERIAUX ISOLANTS...' * page 576, colonne de gauche, alinéa 3 * * page 578, colonne de gauche, alinéa 1 - alinéa 5 * * page 581, colonne de gauche, alinéa 1 - alinéa 3 * * page 583, colonne de droite, alinéa 2 - page 584, colonne de droite, alinéa 1; figures 1,3,6,8 * | 1 | G01R31/12 G01R27/26 |
| A | EP-A-0 470 910 (CEA) * page 3, ligne 53 - page 4, ligne 11 * | 1 | |
| A | JOURNAL OF PHYSICS D APPLIED PHYSICS., vol. 23, no. 1, 14 Janvier 1990 LETCHWORTH GB, pages 75-78, ULANSKI ET AL. 'POLY(PARACYCLOPHANE)-HIGH-MOBILITY PHOTOCONDUCTONG POLYMER' * page 75, colonne de gauche, alinéa 3 - page 76, colonne de gauche, alinéa 2 * | 1 | |
| A | JOURNAL OF PHYSICS D APPLIED PHYSICS., vol. 13, no. 4, Avril 1980 LETCHWORTH GB, pages 611-616, IOANNOU 'A SEM-EBIC MINORITY-CARRIER LIFETIME-MEASUREMENT TECHNIQUE' | | |
| Y | EP-A-0 048 862 (SIEMENS) * page 1, ligne 21 - page 2, ligne 3; figures 1,2 * | 1 | |

**DOMAINES TECHNIQUES RECHERCHES (Int.Cl.6)**

G01R
H01B

-/--

Le présent rapport a été établi pour toutes les revendications

| Lieu de la recherche | Date d'achèvement de la recherche | Examinateur |
|---|---|---|
| LA HAYE | 9 Février 1996 | Iwansson, K |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**Office européen des brevets**

# RAPPORT DE RECHERCHE EUROPEENNE

Numero de la demande

EP 95 40 2436

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | JOURNAL OF PHYSICS D APPLIED PHYSICS., vol. 18, no. 12, Décembre 1985 LETCHWORTH GB, pages 2497-2504, GROSS ET AL. 'CARRIER MOBILITY IN POLY(VINYLIDENE FLUORIDE)' * page 2497; figure 1 * ----- | 2 | |
| | | | **DOMAINES TECHNIQUES RECHERCHES (Int.Cl.6)** |

Le présent rapport a été établi pour toutes les revendications

| Lieu de la recherche | Date d'achèvement de la recherche | Examinateur |
|---|---|---|
| LA HAYE | 9 Février 1996 | Iwansson, K |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.....................................................................
& : membre de la même famille, document correspondant

EPO FORM 1503 03.82 (P04C02)